# EUROPEAN PATENT APPLICATION

(11) **EP 2 908 433 A1**
(43) Date of publication of application: **19.08.2015**
(21) Application number: 15000351.5
(22) Date of filing: 06.02.2015
(51) Int. Cl.: H03F 1/32, H03F 3/45

(54) **Cancellation of distortion induced by elevated op-amp bias current**

(30) Priority: 12.02.2014 US 201461938875 P; 31.10.2014 US 201414530358
(71) Applicant: Linear Technology Corporation, Milpitas, CA 95035-7417 (US)
(72) Inventor: Brisebois, Glen J., San Jose, CA 95132 (US); Perry, Raymond T., South San Francisco, CA 94080 (US); Hoover, Guy M., San Jose, CA 95127 (US)
(74) Representative: Müller-Boré & Partner Patentanwälte PartG mbB

(57) **Abstract**

An operational amplifier circuit reduces signal distortion in switching circuits resulting from flow of bias current through an analog switch having a resistance that changes with a common mode voltage level. The circuit includes an operational amplifier, and first, second, and third switches monolithically integrated on a same integrated circuit substrate. The first switch is connected in a feedback path of the operational amplifier between an output and an inverting input of the operational amplifier. The second and third switches each have one terminal connected to a non-inverting input of the operational amplifier and another terminal receiving a respective input signal, and operate to provide a selected input signal to the amplifier. The first switch operates in a conducting state before, during, and after any period in which any of the second and third switches is in the conducting state. The switches may be analog switches having same operational characteristics.

## Description

### Cross Reference to Related Applications

This application claims the benefit of U.S. Provisional Patent Application No. 61/938,875, filed on February 12, 2014, and of U.S. Patent Application No. 14/530,358, filed on October 31, 2014, which are incorporated herein by reference in their entireties.

### Technical Field

The present subject matter relates to techniques and equipment to reduce signal distortion in switching circuits, and in particular to reducing distortion arising due to a flow of bias current through an analog switch having a resistance that changes with a common mode voltage level.

### Background

Analog signal switches commonly exhibit channel resistance that varies according to the voltage applied to the switch. Additionally, ultra-low noise operational amplifiers commonly draw non-negligible bias currents at their inputs. Hence, when an analog switch is coupled to an input of an ultra-low noise operational amplifier, the flow of bias current through the variable channel resistance of the analog switch gives rise to signal distortion that is coherent with the signal applied to the switch.

In order to reduce the signal distortion caused by the analog switch, the analog switch can be designed to have a low on-resistance, and/or to have high on-resistance flatness so as to reduce on-resistance variation. Alternatively or additionally, an operational amplifier that draws a very low bias current can be used. However, each of these approaches present tradeoffs. For example, operational amplifiers that draw very low bias currents generally include field effect transistors (FETs) that exhibit elevated levels of voltage noise. Other operational amplifiers that have low bias currents may be larger in size, consume more power, and/or be unstable at unity gain. Hence, efforts to reduce signal distortion by using low bias-current amplifiers may result in the introduction of other types of noise into the output signal and thereby fail to adequately improve circuit performance.

A need therefore exists for systems and methods providing reduced signal distortion in switching circuits, and in particular reducing distortion arising due to a flow of bias current through an analog switch having a resistance that changes with a common mode voltage level.

### Summary

The teachings herein alleviate one or more of the above noted problems providing reduced signal distortion in switching circuits, for example by reducing distortion arising due to a flow of bias current through an analog switch having a resistance that changes with a common mode voltage level.

In accordance with one embodiment, an operational amplifier circuit includes an operational amplifier and first, second, and third switches monolithically integrated on a same integrated circuit substrate. The first switch is connected in a feedback path of the operational amplifier between an output of the operational amplifier and an inverting input of the operational amplifier and operates in a conducting state. The second and third switches each have one terminal connected to a non-inverting input of the operational amplifier and another terminal receiving a respective input signal, and operate to provide a selected one of the respective input signals to the non-inverting input of the operational amplifier.

The first, second, and third switches may be analog switches having substantially the same operational characteristics as each other.

The first, second, and third switches may be analog switches having substantially the same size as each other.

The operational amplifier circuit may further include control circuitry connected to a control input of the first switch and operative to maintain the first switch in the conducting state at all times.

The operational amplifier circuit may further include control circuitry connected to a control input of the first switch and operative to continuously maintain the first switch in the conducting state for a period of time extending from before to after any period in which any of the second and third switches is in the conducting state.

The operational amplifier circuit may further include a multiplexer including the second and third switches and monolithically integrated on the same integrated circuit substrate as the first, second, and third switches. The multiplexer may include control circuitry monolithically integrated on the same integrated circuit substrate and connected to control inputs of the second and third switches to selectively control the second and third switches in the conducting state.

The operational amplifier circuit may further include an analog-to-digital converter monolithically integrated on the same integrated circuit substrate as the first, second, and third switches. The first switch may be electrically connected to the analog-to-digital converter.

The operational amplifier circuit may further include a digital-to-analog converter monolithically integrated on the same integrated circuit substrate as the first, second, and third switches. The second and third switches may be electrically connected to the digital-to-analog converter.

The operational amplifier may be an ultra-low noise operational amplifier that is monolithically integrated on the same integrated circuit substrate as the first, second, and third switches.

In accordance with another embodiment, an integrated circuit includes an integrated circuit substrate having thereon first and second feed-forward switches and a feedback switch, and an operational amplifier connected to the integrated circuit substrate. The feedback switch operates in a conducting state. The operational amplifier is connected to the integrated circuit substrate such that the first and second feed-forward switches are both connected to a non-inverting input of the operational amplifier, and the feedback switch is connected in a feedback path of the operational amplifier between an output of the operational amplifier and an inverting input of the operational amplifier.

The first and second feed-forward switches and the feedback switch may be analog switches having substantially the same operational characteristics as each other.

The first and second feed-forward switches and the feedback switch may be analog switches having substantially the same dimensions as each other on the integrated circuit substrate.

The feedback switch may be continuously maintained in the conducting state for a period of time extending from before to after any period in which any of the feed-forward switches is in the conducting state.

The integrated circuit substrate may include a multiplexer thereon that includes the first and second feed-forward switches.

The integrated circuit substrate may further include analog-to-digital converter circuitry thereon.

The integrated circuit substrate may further include digital-to-analog converter circuitry thereon.

The operational amplifier may be an ultra-low noise operational amplifier that is monolithically integrated on the integrated circuit substrate with the feed-forward switches and the feedback switch.

Additional advantages and novel features will be set forth in part in the description which follows, and in part will become apparent to those skilled in the art upon examination of the following and the accompanying drawings or may be learned by production or operation of the examples. The advantages of the present teachings may be realized and attained by practice or use of various aspects of the methodologies, instrumentalities and combinations set forth in the detailed examples discussed below.

### Brief Description of the Drawings

The drawing figures depict one or more implementations in accord with the present teachings, by way of example only, not by way of limitation. In the figures, like reference numerals refer to the same or similar elements.
FIG. 1 is a circuit diagram of an operational amplifier circuit including an operational amplifier having a multiplexer connected to its non-inverting input.
FIG. 2 is a circuit diagram of an operational amplifier circuit including an operational amplifier having a multiplexer connected to its non-inverting input and a mimic switch connected in the feedback path of the operational amplifier to reduce signal distortion.
FIGS. 3 and 4 are circuit diagrams of operational amplifier circuits showing variations of the circuit of FIG. 2.
FIG. 5 is a high-level functional block diagram of an exemplary integrated circuit substrate having feed-forward switches and a feedback switch formed thereon for implementing the circuit of FIG. 2.

### Detailed Description

In the following detailed description, numerous specific details are set forth by way of examples in order to provide a thorough understanding of the relevant teachings. However, it should be apparent to those skilled in the art that the present teachings may be practiced without such details. In other instances, well known methods, procedures, components, and/or circuitry have been described at a relatively high-level, without detail, in order to avoid unnecessarily obscuring aspects of the present teachings.

The various circuits and methods disclosed herein relate to reducing overall signal distortion in switching circuits, and in particular to reducing distortion that arises due to flow of bias current through an analog switch having a resistance that changes with a common mode voltage level.

Reference now is made in detail to the examples illustrated in the accompanying drawings and discussed below.

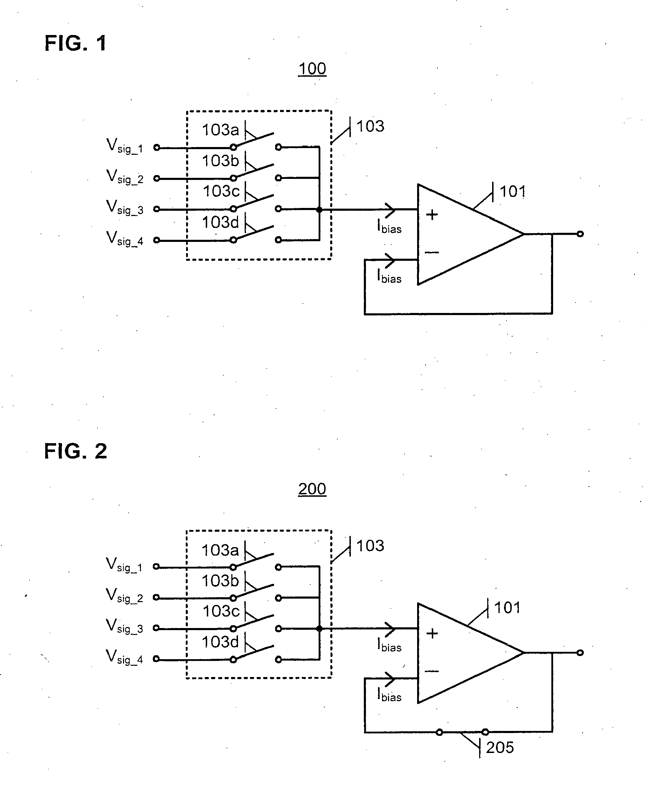

FIG. 1 illustrates an operational amplifier circuit 100 including an operational amplifier 101 having a multiplexer 103 connected to its non-inverting input. In the illustration, the multiplexer 103 includes four switches 103a-d connected to the non-inverting input of the operation amplifier. Each switch 103a-d receives a corresponding input signal V_{sig_1-4}, and the multiplexer 101 is operative to selectively connect one of the input signals V_{sig_1-4} to the non-inverting input of the operational amplifier 101. The operational amplifier 101 is connected in a buffering configuration with the inverting input coupled to the output.

The switches 103a-d are analog switches that have a channel resistance R_{ch} when in the conducting (or 'On', or closed) state. The channel resistance R_{ch}, however, varies with the amplitude of the voltage applied to the switch. In one example, the channel resistance R_{ch} may increase from a low value R_{ch_min} to a high value R_{ch_max} as a voltage applied to the switch increases from 0 V to an amplitude V_{ch}, and decrease below the high value R_{ch_max} as the voltage applied to the switch increases above V_{ch}. In other examples, the channel resistance R_{ch} may vary differently with respect to the voltage applied to the switch. The switches 103a-d generally are analog switches fabricated on an integrated circuit substrate, and the voltage applied to the switch corresponds to the voltage applied to the switch measured with respect to the integrated circuit's ground terminal.

Additionally, the operational amplifier 101 is an analog amplifier designed to have very low noise. The operational amplifier 101 includes bipolar junction transistors (BJTs) that draw non-negligible currents through their base terminal. As a result, the operational amplifier 101 draws a non-negligible bias current I_{bias} through its inverting and non-inverting inputs. In one example, the bias current I_{bias} has an amplitude of approximately 5 uA; in other examples, the bias current I_{bias} has an amplitude in the range 0.1-100 uA. In general, in order to ensure very low noise operation, the operational amplifier 101 does not include any metal-oxide-semiconductor (MOS) transistors or field effect transistors (FETs).

In the operational amplifier circuit 100, the bias current I_{bias} flows through the multiplexer 103. Specifically, the bias current I_{bias} flows through one of the switches 103a-d that is in a conducting state and causes a voltage I_{bias}*R_{ch} to be dropped across the switch. Because the channel resistance R_{ch} of the switch varies with the voltage applied to the switch, the voltage drop I_{bias}*R_{ch} across the switch varies with the amplitude voltage applied to the switch (e.g., V_{sig_2} in an example in which switch 103b is in a conducting state). The resulting voltage drop across the switch thus produces a distortion that is coherent with the applied input signal (e.g., V_{sig_2}) and therefore cannot readily be filtered out or otherwise distinguished from the signal.

The circuit of FIG. 2 can advantageously be used to reduce the distortion caused by the flow of the bias current I_{bias} through the variable channel resistance R_{ch} of the multiplexer switches 103a-d.

FIG. 2 illustrates an operational amplifier circuit 200 that includes many of the same components as circuit 100, including operational amplifier 101 and multiplexer 103. Reference can be made to the description of circuit 100 above for detailed information on similar components in the two circuits. In operational amplifier circuit 200, an additional mimic switch 205 is connected in the feedback path of the operational amplifier 101 between the output and the inverting input of the operational amplifier 101.

The mimic switch 205 is generally maintained in the conducting (or 'On' or closed) position, and is in particular continuously maintained in the conduction position for a period extending from before, during, and to after any period in which any of switches 103a-d is in a conducting position. For example, the mimic switch may be continuously maintained in the conduction position for a period extending from before (e.g., 1, 10, or 100 milliseconds before) to after (e.g., 1, 10, or 100 milliseconds after) any period in which any of switches 103a-d is in the conducting position. In some examples, the mimic switch 205 is maintained in the conducting position at all times so as to maintain the operational amplifier 101 in a closed-loop feedback configuration and avoid causing the operational amplifier 101 to operate in an open-loop high-gain configuration.

Additionally, the mimic switch 205 is generally selected to have the same characteristics as the switches 103a-d connected to the non-inverting input of the operational amplifier 101. For example, the mimic switch 205 can be monolithically integrated on the same integrated circuit substrate or package as the switches 103a-d, and/or can have the same size as the switches 103a-d. As such, the mimic switch 205 will exhibit a channel resistance R_{ch} having substantially the same characteristic as the channel resistance of the switches 103a-d. Additionally, because the operational amplifier 101 is operative to maintain the inverting and non-inverting inputs at substantially the same voltage potential, the voltages applied to the switches 103a-d and to the mimic switch 205 are substantially the same and the switches 103a-d and the mimic switch 205 will therefore exhibit similar channel resistances R_{ch}. Furthermore, because the operational amplifier 101 draws substantially the same bias current I_{bias} through the inverting and non-inverting inputs, the voltage drop across the mimic switch 205 will be substantially the same as the voltage drop across the multiplexer switches 103a-d. Hence, any distortion resulting from the flow of bias current through the multiplexer switches 103a-d and applied to the operational amplifier's non-inverting input will be similarly applied via the bias switch 205 to the operational amplifier's inverting input. Hence, the distortion will appear as a common mode distortion at the operational amplifier's inputs, and will be filtered out and attenuated by the operational amplifier 101 according to the amplifier's common mode rejection ratio (CMRR).

The application of the mimic switch as disclosed allows for the use of high bias current operational amplifiers such as ultra-low noise operational amplifiers, without paying the penalty of the distortion due to switch impedance variations multiplying with bias current. It thus allows for the use of amplifiers with elevated bias currents that would otherwise not be usable in the circuit due to excessive distortion. Additionally, the use of ultra-low noise operational amplifiers with relatively high bias currents is advantageous over FET-based operational amplifiers because FET-based operational amplifiers typically have higher voltage noise.

The connection of similar switches to both inputs of the operational amplifier 101 can effectively cancel DC errors due to the flow of the bias current I_{bias}. This has the effect of forcing bias current induced errors to behave as input common mode error, and thereby reduce their appearance at the output. Further, this reduces the effect of channel variation with common mode by applying an identical (or substantially identical) switch 205 in the feedback path. This way, the bias currents of the amplifier inputs are forced through substantially identical R_{ch} +/- R_{delta} impedances, and the distortion is forced to appear as a common mode at the inputs, and is therefore reduced at the output.

In one operational example, the circuits of FIGS. 1 and 2 were implemented using commercially available integrated circuit components. An operational amplifier with a 5 uA typical bias current was signaled from an analog switch with approximately +/- 5 Ohms of channel impedance variation R_{delta} with common mode. The resulting distortion was therefore on the order of 5uA * 5 Ohms = 25uV. On a 4 Vₚₑₐₖ₋ₜₒ₋ₚₑₐₖ signal, measured distortion was -97 dBc (THD), indicating the presence of tens of microvolts of distortion. By placing a mimic switch in feedback path of the operational amplifier (e.g., by using an additional switch available on a commercially available analog-to-digital or digital-to-analog converter integrated circuit component) as described in relation to FIG. 2, the achieved distortion was immediately reduced to -108 dBc. The gain of 11 dBc presents a notable improvement in circuit performance.

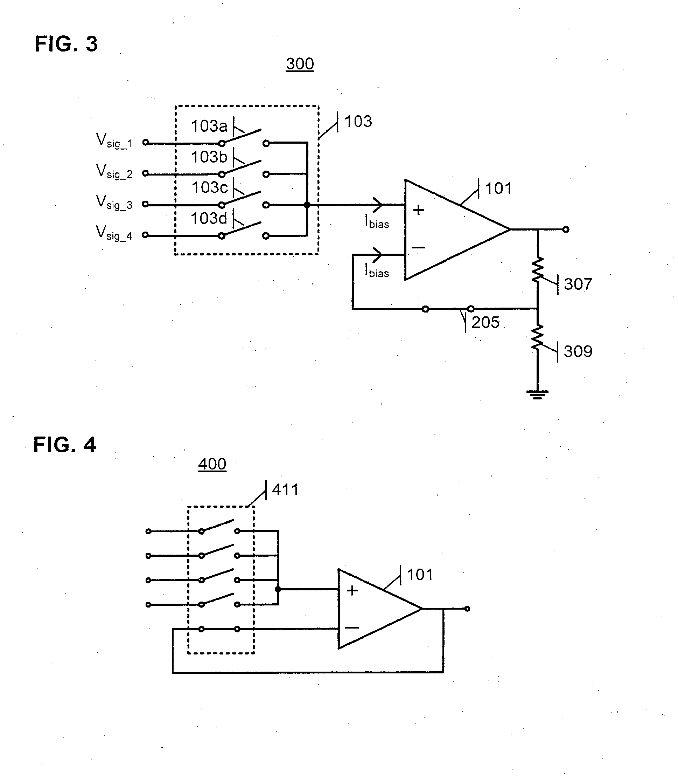

FIG. 3 illustrates an operational amplifier circuit 300 similar to the circuit 200 of FIG. 2, and in which additional components are connected in the feedback path of the operational amplifier 101. As shown in FIG. 3, the feedback path has impedance elements 307 and 309 connected in series between the output node of the operational amplifier 101 and ground. The impedance elements 307 and 309 form a voltage divider in the feedback path of the operational amplifier 101 such that the voltage fed back to the inverting input of the amplifier is determined based on the ratio of the impedance of 307 to the sum of the impedances of 307 and 309. For example, if the impedance elements 307 and 309 are resistors having the same value (e.g., 1 kilo-ohm), the voltage fed back to the inverting input of the amplifier is one-half of the output voltage of the amplifier.

Various other modifications to the circuit 200 of FIG. 2 can be made while retaining the operational benefits described above. In general, however, the mimic switch 205 will have one terminal directly connected to the inverting input of the operational amplifier 101. In addition, the mimic switch 205 will generally not have any other circuit components coupled in parallel with it. Further, as noted above, the mimic switch 205 can remain in a conducting state at all times, and is continuously maintained in the conducting state from before, to during, and to after any period in which any of switches 103a-d is in the conducting state.

As detailed above, the mimic switch 205 should have substantially the same characteristics as the switches 103a-d in order to most effectively reduce signal distortion. In general, the mimic switch 205 is fabricated on the same monolithic integrated circuit substrate as the switches 103a-d, and has the same size as the switches 103a-d. For example, FIG. 4 shows an illustrative operational amplifier circuit 400 that includes a monolithically integrated circuit component 411 including a plurality of switches (five switches, in the illustrated example). The monolithically integrated circuit component 411 is connected to operational amplifier 101 so as to replicate the circuit 200 shown in FIG. 2. In particular, terminals of four of the switches are coupled together and to the non-inverting input of the operational amplifier 101 in order to replicate the multiplexer 103. The four switches of component 411 function as the multiplexer switches 103a-d of circuit 200. Further, the fifth switch is connected in the feedback path of the operational amplifier 101 between the output and the inverting input of the operational amplifier 101. Because the switches of the integrated circuit component 411 are fabricated to be monolithically integrated together, operational characteristics of the switches can be closely matched such that each of the switches exhibits a substantially identical channel resistance R_{ch} characteristic (including substantially identical variations in channel resistance R_{ch} with respect to a common mode applied to the switch). As in the case of circuit 200, the fifth switch of the component 411 can be held in a conducting (or 'On' or closed) position at all times so as to maintain the operational amplifier 101 in a closed-loop feedback configuration. Alternatively, the fifth switch is continuously maintained in the conducting state from before, to during, and to after any period in which any of the four other switches of component 411 is in the conducting state. The fifth switch is continuously maintained in the conducting state from before to after any period in which any of the four other switches of component 411 is in the conducting state such that switching of the fifth switch does not occur concurrently with, in parallel with, or in synchrony with switching of any of the four other switches.

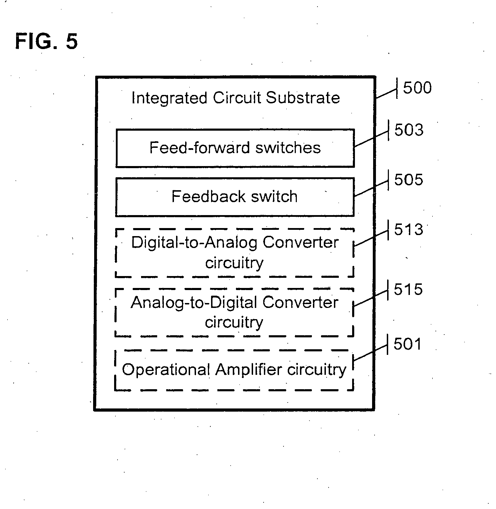

FIG. 5 is a block diagram illustratively showing an integrated circuit substrate 500 having monolithically integrated circuitry formed thereon. The circuitry of FIG. 5 can alternatively be integrated within a same integrated circuit package, even if the circuitry is formed on separate substrates. As shown, the integrated circuit substrate 500 has a plurality of feed-forward switches 503 formed thereon (e.g., first, second, third, ... feed-forward switches), wherein the plurality of feed-forward switches can be used as switches 103a-d of circuit 200 for example. In general, each feed-forward switch includes two switch terminals and a control input selectively controlling the operational state of the switch between a conducting state and a non-conducting state. The feed-forward switches 503 can form part of or be connected so as to implement a multiplexer such as multiplexer 103. The connection of the feed-forward switches 503 to implement the multiplexer can include logic circuitry for controlling the control inputs of each of the feed-forward switches 503 so as to implement multiplexer functionality (e.g., logic circuitry controlling the feed-forward switches 503 such that only a single one of the feed-forward switches 503 is in a conducting state at any time).

The integrated circuit substrate 500 further includes at least one feedback switch 505 that can be used as mimic switch 205 of circuit 200. The feedback switch 505 includes two switch terminals. In operation, the feedback switch 505 can remain in the conducting state at all times. As a result, a control input of the feedback switch 505 can be wired so as to maintain the feedback switch 505 in the conducting state at all times. Alternatively, the control input of the feedback switch 505 can be wired so as to maintain the feedback switch 505 to be continuously held in the conducting state from before, to during, and to after any period in which any of the feed-forward switches 503 is in the conducting state. The feedback switch 505 can be monolithically fabricated on the substrate 500 with the feed-forward switches 503 to have the same physical (e.g., dimensions) and operational characteristics (e.g., R_{ch} and R_{ch} variation) as the feed-forward switches 503. In general, the feedback switch 505 is formed on the substrate 500 as part of a same fabrication process used to form the feed-forward switches 503 on the substrate 500.

The integrated circuit substrate 500 can further include additional circuitry formed thereon. For example, the substrate 500 can optionally include digital-to-analog converter circuitry 513 and/or analog-to-digital converter circuitry 515. In some examples, the switches 103a-d and 205 of circuit 200 can form part of or be electrically connected to the digital-to-analog converter circuitry 513 and/or the analog-to-digital converter circuitry 515, for example by forming part of input or output circuitry of the converter circuitry 513 or 515 or carrying signals to/from the converter. The digital-to-analog converter circuitry 513 and/or analog-to-digital converter circuitry 515 is monolithically integrated with the feed-forward switches 503 and feedback switch 505 on the substrate 500. In some examples, the converter circuitry 513 and/or 515 is monolithically integrated using a biCMOS process on a same die as the switches 503 and 505 and as the amplifier circuitry 501.

In one example, the feed-forward switches 503 are connected to an external signal source; in another example, the feed-forward switches 503 are electrically connected to some other circuit such as an output of a digital-to-analog converter 513. In such examples, the feed-forward switches 503 provide the signal from the external signal source and/or from the digital-to-analog converter 513 to the operational amplifier 101. In a further example, the feedback switch 505 (and, optionally, an output node of operational amplifier circuitry 501 such as an output of operational amplifier 101) are connected to an input of an analog-to-digital converter 515. In the further example, the signal at the output of the operational amplifier 101 is provided to the input of the analog-to-digital converter.

In another example, the substrate 500 optionally includes operational amplifier circuitry 501 such as circuitry used to implement operational amplifier 101 of circuit 200, for example. The substrate 500 can further optionally include impedance elements (e.g., such as 307 and 309) and other circuitry for connection to the feed-forward switches 503 and feedback switch 505.

In all examples above, the integrated circuit substrate 500 includes interconnection circuitry for interconnecting the feed-forward switches 503, the feedback switch 505, and any other circuitry (e.g., 501, 513, 515) optionally included on the integrated circuit substrate 500 to provide the functionality described above in relation to circuits 200, 300, and 400. The integrated circuit substrate 500 can further include input/output pads for connecting the circuitry on the integrated circuit substrate 500 to a device package and/or to circuitry that is not integrated on the substrate 500.

Unless otherwise stated, all measurements, values, ratings, positions, magnitudes, sizes, and other specifications that are set forth in this specification, including in the claims that follow, are approximate, not exact. They are intended to have a reasonable range that is consistent with the functions to which they relate and with what is customary in the art to which they pertain.

The scope of protection is limited solely by the claims that now follow. That scope is intended and should be interpreted to be as broad as is consistent with the ordinary meaning of the language that is used in the claims when interpreted in light of this specification and the prosecution history that follows and to encompass all structural and functional equivalents. Notwithstanding, none of the claims are intended to embrace subject matter that fails to satisfy the requirement of Sections 101, 102, or 103 of the Patent Act, nor should they be interpreted in such a way. Any unintended embracement of such subject matter is hereby disclaimed.

Except as stated immediately above, nothing that has been stated or illustrated is intended or should be interpreted to cause a dedication of any component, step, feature, object, benefit, advantage, or equivalent to the public, regardless of whether it is or is not recited in the claims.

It will be understood that the terms and expressions used herein have the ordinary meaning as is accorded to such terms and expressions with respect to their corresponding respective areas of inquiry and study except where specific meanings have otherwise been set forth herein. Relational terms such as first and second and the like may be used solely to distinguish one entity or action from another without necessarily requiring or implying any actual such relationship or order between such entities or actions. The terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element proceeded by "a" or "an" does not, without further constraints, preclude the existence of additional identical elements in the process, method, article, or apparatus that comprises the element.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

While the foregoing has described what are considered to be the best mode and/or other examples, it is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings.

## Claims

1. An operational amplifier circuit comprising:
an operational amplifier; and
first, second, and third switches monolithically integrated on a same integrated circuit substrate,
wherein the first switch is connected in a feedback path of the operational amplifier between an output of the operational amplifier and an inverting input of the operational amplifier and operates in a conducting state, and
wherein the second and third switches each have one terminal connected to a non-inverting input of the operational amplifier and another terminal receiving a respective input signal, and operate to provide a selected one of the respective input signals to the non-inverting input of the operational amplifier.

2. The operational amplifier circuit of claim 1, wherein the first, second, and third switches are analog switches having substantially the same operational characteristics as each other.

3. The operational amplifier circuit of claim 1 or 2, wherein the first, second, and third switches are analog switches having substantially the same size as each other.

4. The operational amplifier circuit according to any one of claims 1 to 3, further comprising:
control circuitry connected to a control input of the first switch and operative to maintain the first switch in the conducting state at all times.

5. The operational amplifier circuit according to any one of claims 1 to 3, further comprising:
control circuitry connected to a control input of the first switch and operative to continuously maintain the first switch in the conducting state for a period of time extending from before to after any period in which any of the second and third switches is in the conducting state.

6. The operational amplifier circuit according to any one of claims 1 to 5, further comprising:
a multiplexer comprising the second and third switches and monolithically integrated on the same integrated circuit substrate as the first, second, and third switches,
wherein the multiplexer includes control circuitry monolithically integrated on the same integrated circuit substrate and connected to control inputs of the second and third switches to selectively control the second and third switches in the conducting state.

7. The operational amplifier circuit according to any one of claims 1 to 6, further comprising:
an analog-to-digital converter monolithically integrated on the same integrated circuit substrate as the first, second, and third switches,
wherein the first switch is electrically connected to the analog-to-digital converter.

8. The operational amplifier circuit according to any one of claims 1 to 7, further comprising:
a digital-to-analog converter monolithically integrated on the same integrated circuit substrate as the first, second, and third switches,
wherein the second and third switches are electrically connected to the digital-to-analog converter.

9. The operational amplifier circuit according to any one of claims 1 to 8, wherein the operational amplifier is an ultra-low noise operational amplifier that is monolithically integrated on the same integrated circuit substrate as the first, second, and third switches.

10. An integrated circuit comprising:
an integrated circuit substrate having thereon first and second feed-forward switches and a feedback switch; and
an operational amplifier connected to the integrated circuit substrate,
wherein the feedback switch operates in a conducting state; and
wherein the operational amplifier is connected to the integrated circuit substrate such that the first and second feed-forward switches are both connected to a non-inverting input of the operational amplifier, and the feedback switch is connected in a feedback path of the operational amplifier between an output of the operational amplifier and an inverting input of the operational amplifier.

11. The integrated circuit of claim 10, wherein the first and second feed-forward switches and the feedback switch are analog switches having substantially the same operational characteristics as each other.

12. The integrated circuit of claim 10 or 11, wherein the first and second feed-forward switches and the feedback switch are analog switches having substantially the same dimensions as each other on the integrated circuit substrate.

13. The integrated circuit according to any one of claims 10 to 12, wherein the feedback switch is continuously maintained in the conducting state for a period of time extending from before to after any period in which any of the feed-forward switches is in the conducting state.

14. The integrated circuit according to any one of claims 10 to 13, wherein the integrated circuit substrate has a multiplexer thereon that includes the first and second feed-forward switches, or
wherein the integrated circuit substrate further comprises analog-to-digital converter circuitry thereon, or
wherein the integrated circuit substrate further comprises digital-to-analog converter circuitry thereon.

15. The integrated circuit according to any one of claims 10 to 14, wherein the operational amplifier is an ultra-low noise operational amplifier that is monolithically integrated on the integrated circuit substrate with the feed-forward switches and the feedback switch.
